## Europäisches Patentamt
## European Patent Office
## Office européen des brevets

(11) Veröffentlichungsnummer: **0 054 811**
**A1**

(12) **EUROPÄISCHE PATENTANMELDUNG**

(21) Anmeldenummer: **81110188.0**

(22) Anmeldetag: **05.12.81**

(51) Int. Cl.³: **H 04 B 3/14**

(30) Priorität: **16.12.80 DE 3047292**

(43) Veröffentlichungstag der Anmeldung: **30.06.82**
**Patentblatt 82/26**

(84) Benannte Vertragsstaaten: **BE DE FR GB IT LU NL**

(71) Anmelder: **Licentia Patent-Verwaltungs-GmbH, Theodor-Stern-Kai 1, D-6000 Frankfurt/Main 70 (DE)**

(72) Erfinder: **Schneider, Wolfgang, Dr.-Ing, Kalköfele 3, D-7900 Ulm (DE)**
Erfinder: **Maly, Horst, Ing. grad, In der Wanne 20, D-7900 Ulm (DE)**

(74) Vertreter: **Schickle, Gerhard, Dipl.-Ing. et al, Licentia Patent-Verwaltungs-GmbH Theodor-Stern-Kai 1, D-6000 Frankfurt/Main 70 (DE)**

(54) **Entzerrer zum Entzerren von nichtlinear verzerrten Signalen.**

(57) Zur Entzerrung von nichtlinear verzerrten Signalen enthält der Verzerrer am Eingang (E') eine Verzweigung in wenigstens zwei Äste (St0, St1, St2,...), die in einer gemeinsamen Summen/Differenz-Bildungseinrichtung (SD'-Einrichtung) am Entzerrerausgang (Au') wieder zusammengeführt werden. Mit Ausnahme des ersten Astes (St0) enthalten die übrigen Äste mindestens einen Funktionsgeber (f) zur Erzeugung von Verzerrungen höherer Ordnung. Ferner ist jeder Ast in zwei Wege aufgeteilt mit einem steuerbaren Bewertungsglied (B1) in einem Weg und der Reihenschaltung eines steuerbaren Bewertungsgliedes (B'1) und eines Quadraturfilters (Q) im anderen Weg, die am Ausgang durch ein Summierglied (11) wieder vereint werden.

0054811

Licentia Patentverwaltungs-GmbH      Z13 PTL-UL/Sar/lh
Theodor-Stern-Kai 1                   UL 79/136
D-6000 Frankfurt 70                   Aktz.: P 30 47 292.5

Beschreibung

Entzerrer zum Entzerren von nichtlinear verzerrten
Signalen

Die Erfindung bezieht sich auf einen Entzerrer zum
Entzerren von nichtlinear verzerrten Signalen, wie im
Oberbegriff des Patentanspruchs 1 angegeben.

Analoge Übertragungssysteme, wie beispielsweise Trägerfrequenz- oder Richtfunksysteme für den Trägerfrequenz-
und Fernsehprogramm-Weitverkehr haben in der Regel eine
Struktur, bei der abwechselnd aufeinanderfolgend passive
lineare Filter und aktive Bausteine hintereinandergeschaltet sind. Bei der Realisierung solcher Systeme ergibt

...

sich das Problem, daß Unebenheiten in den Frequenzgängen der Filter und Nichtlinearitäten in den aktiven Bausteinen (Verstärker, Mischer und dergleichen) prinzipiell nicht vermeidbar sind. Die Folge ist, daß das Ausgangssignal der Übertragungsstrecke je nach dem technischen Aufwand mit mehr oder weniger starken Verzerrungen gegenüber dem Eingangssignal behaftet ist, die im allgemeinen von sehr verwickelter, nichtlinearer Natur sein können. Dadurch ist bei Vielkanalsystemen im Frequenzmultiplex stets mit einer gewissen Interkanalmodulationsstörung zu rechnen.

Es sind bereits verschiedene Verfahren zur Reduktion dieser nichtlinearen Verzerrungen geläufig. Das bekannte Verfahren der Gegenkopplung, bei dem ein bestimmter Teil des Ausgangssignals auf den Eingang im Sinne einer Verstärkungsreduktion gegengekoppelt ist, hat den Nachteil, daß es einer Stabilitätsbedingung unterliegt, die bei höheren Frequenzen immer schwieriger und bei Mikrowellenendstufen z.B. mit Wanderfeldröhren überhaupt nicht mehr erfüllbar ist.

Für diejenigen Fälle, bei denen die Gegenkopplung an der Stabilitätsbedingung scheitert, sind Kompensationsschaltungen entstanden, bei denen durch ganz spezielle nichtlineare Schaltungen die Verzerrung entweder durch einen inversen Verzerrer beseitigt werden soll oder durch Überlagerung kompensierender Verzerrungen in umgekehrter Polarität gegenüber den systembedingten Verzerrungen diese kompensiert werden.

Da aber bei nichtlinearen dynamischen Systemen das kommutative Gesetz allgemein nicht gültig ist, leiden diese Konzepte im allgemeinen an dem Mangel, daß die Struktur und quantitative Bemessung dieser Schaltungsanordnungen fest mit der zu entzerrenden Anordnung verknüpft ist. Bei einer Übertragungskette veränderlicher Länge würden diese Verfahren die gliedweise Entzerrung der einzelnen Kettenglieder durch jeweils zugeordnete Verzerrer bedeuten mit der Folge, daß der technische Entzerrungsaufwand proportional mit der Zahl der Kettenglieder der Übertragungsstrecke zunimmt.

Aus der DE-OS 30 02 995 ist nun ein anpaßbares Entzerrungssystem bei Nichtlinearitäten bekannt geworden, mit einem Eingangs- und einem Ausgangsanschluß und einem dazwischengeschalteten zu entzerrenden Schaltkreis, wobei der Ausgangsanschluß ein entzerrtes Ausgangssignal liefert. Der Entzerrerschaltkreis kann in Serie mit dem zu entzerrenden Schaltkreis angeordnet werden. Nahe dem Entzerrereingang ist eine Verzweigung vorgesehen in wenigstens zwei Äste, denen eine gemeinsame Summen/Differenz-Bildungseinrichtung nahe dem Entzerrerausgang nachgeschaltet ist. Ferner können gegebenenfalls weitere Äste vorgesehen sein, die sich vom zweiten Ast dadurch unterscheiden, daß ihre Funktionsgeber für unterschiedliche Ordnungen vorgesehen sind. Bei den hier erforderlichen Phasenschiebern muß die Phase des vorverzerrten Signals um 360° frequenzunabhängig innerhalb des gesamten Übertragungsbereichs einstellbar sein. Diese Forderung ist jedoch nicht in gewünschter Weise erfüllbar, so daß mit solchen Entzerrern lediglich Entzerrungsdämpfungen von etwa 20 dB erreichbar sind.

Der Erfindung liegt die Aufgabe zugrunde, den Stand der

...

Technik zu verbessern. Insbesondere soll eine Entzerrerschaltung der eingangs genannten Art angegeben werden, mit
der sich eine wirkungsvolle Reduzierung der Verzerrungsleistung bei möglichst geringem Aufwand erzielen läßt.

Diese Aufgabe wird gelöst durch Entzerrer mit den Merkmalen der Patentansprüche 1, 2 oder 3. Durch die Verwendung von Quadraturfiltern werden die vorverzerrten Signale
in karthesische Koordinaten aufgespalten, mit deren bewerteten Komponenten die zu entzerrenden Signalkomponenten
vollständig kompensierbar sind. Da Quadraturfilter über
einen weiten Freuquenzbereich frequenzunabhängig realisierbar sind, lassen sich mit den erforderlichen Funktionsgebern Reduzierungen von Verzerrungsleistungen bis zu
35 dB erzielen.

Vorteilhafte Weiterbildungen sind in den Unteransprüchen
angegeben. Ein besonderer Vorteil der Erfindung besteht
darin, daß sich der Entzerrer zu einem adaptiven Entzerrer
weiterbilden läßt, der vielseitig verwendbar ist. Eine
besonders vorteilhafte Schaltungsanordnung eines Funktionsgebers mit Bewertungsglied, insbesondere für das
Ausführungsbeispiel nach Patentanspruch 3, gibt Patentanspruch 6.

Anhand der Zeichnungen wird die Erfindung mit drei
Ausführungsbeispielen näher erläutert. Es zeigen:

Figuren 1 und 2: Blockschaltbilder und zugehörige vereinfachte Darstellungsweisen für Baugruppen, die in den
Figuren 3 und 4 verwendet sind;

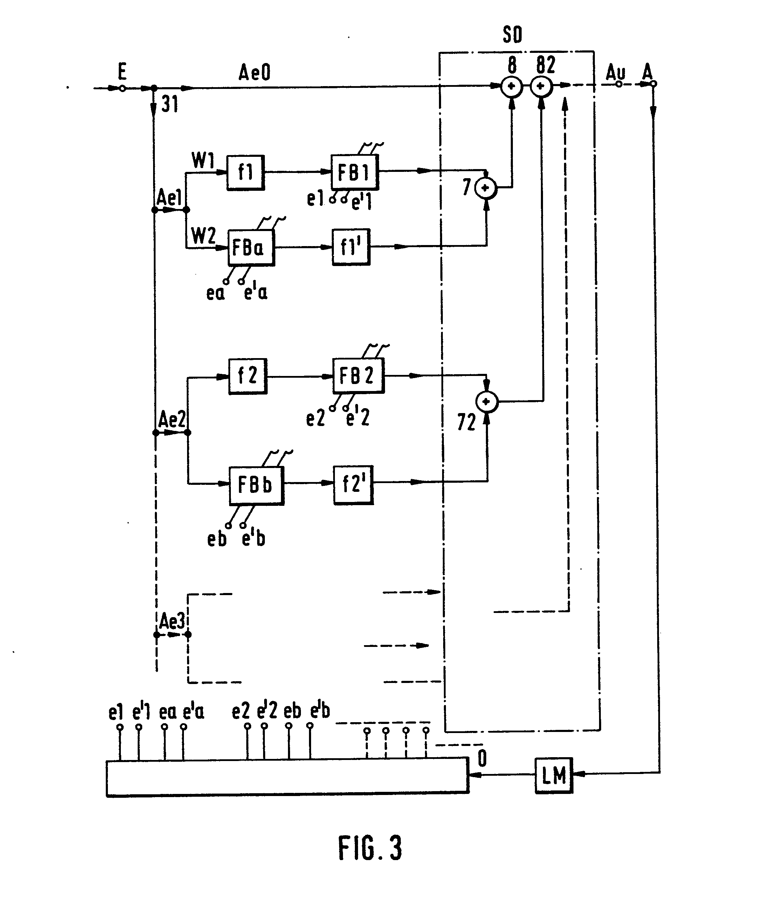

Figur 3: ein erstes Ausführungsbeispiel eines erfindungsgemäßen Entzerrers;

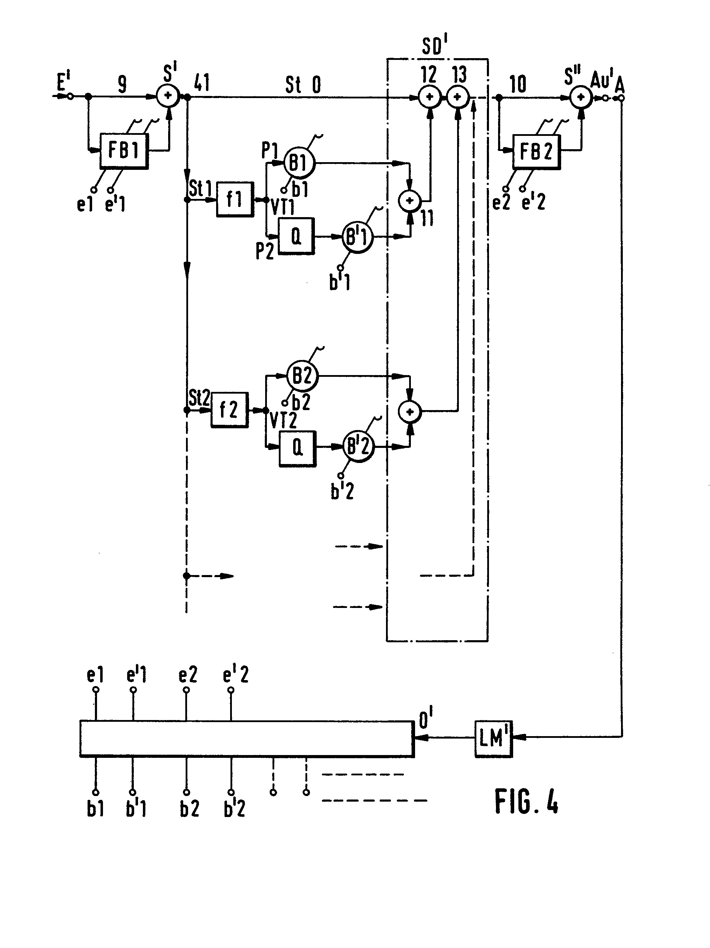

Figur 4: ein zweites Ausführungsbeispiel eines erfindungsgemäßen Entzerrers;

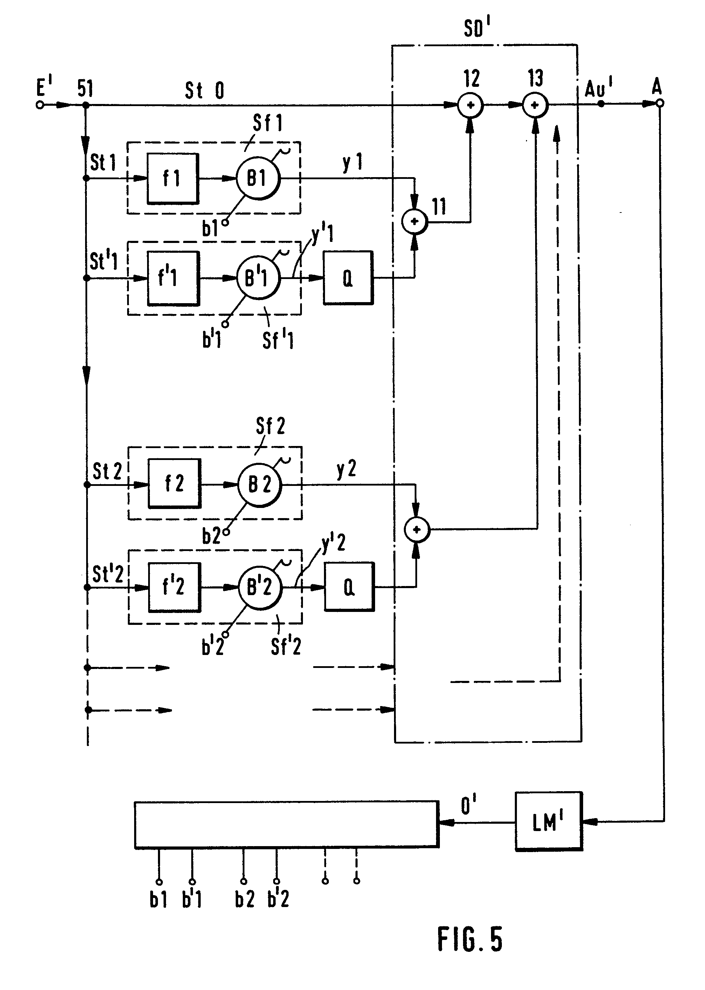

Figur 5: ein drittes Ausführungsbeispiel eines erfindungsgemäßen Entzerrers, für den Fall, daß dynamische Verzerrungen vernachlässigbar sind;

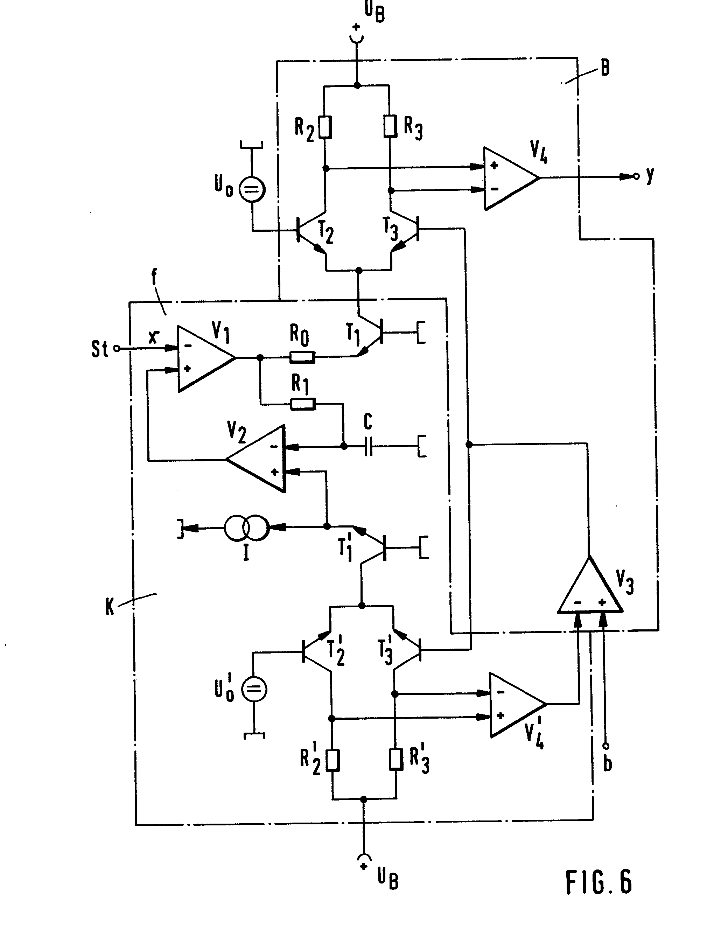

Figur 6: Schaltbild eines integrierbaren Funktionsgebers
mit Bewertungsglied.

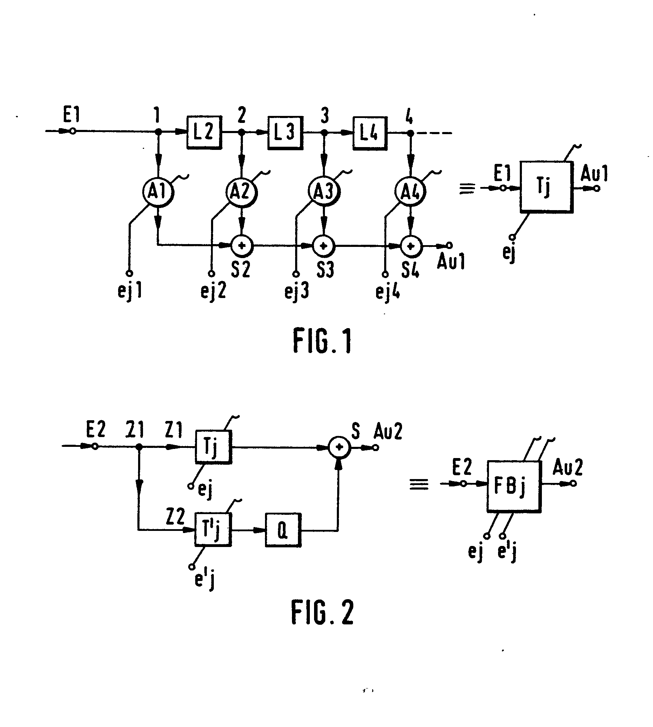

In **FIG. 1** ist links der prinzipielle Aufbau eines Transversalfilters mit elektronisch einstellbaren Gewichtsfaktoren und rechts eine vereinfachte Darstellungsweise
angegeben. Das Transversalfilter Tj weist einen Eingang E1
auf, an welchen eine Kette von hintereinandergeschalteten
Laufzeitgliedern L2, L3,... mit untereinander gleichen
Laufzeiten angeschlossen ist. Am Eingang des ersten
Laufzeitgliedes L2 und an jedem Ausgang der Laufzeitglieder L2, L3,... ist ein Abgriff 1 bzw. 2, 3,... vorgesehen,
von wo Signale abgezweigt werden. Diese Bewertungsglieder,
beispielsweise Dämpfungsglieder mit einstellbarer Dämpfung, werden bezüglich ihres Bewertungsfaktors (Dämpfungsfaktors) gesteuert über Steuereingänge ej1, ej2,
ej3,... . Von den Ausgängen der Bewertungsglieder gelangen
die bewerteten Signale über Summierer S2, S3,... zu dem
Ausgang Au1 des Transversalfilters Tj, dessen Vielfach von
Steuereingängen im rechten Teil der Figur 1 abgekürzt mit
ej bezeichnet ist. Die Anzahl der erforderlichen Laufzeitglieder hängt vom zu korrigierenden Fehler des Frequenzganges ab.

In **FIG. 2** ist links als Blockschaltbild und rechts als
gleichwertige, vereinfachte Darstellung ein Filterblock
FBj dargestellt, in welchem zwischen einem Eingang E2 und

...

einem Ausgang Au2 zwei Transversalfilter Tj bzw. T'j entsprechend FIG. 1 verwendet sind. Sie liegen jeweils in einem von zwei Zweigen Z1, Z2, die von einer eingangsnahen Verzweigung 21 ausgehen und an einem ausgangsnahen Summen- oder Differenzbildner S wieder zusammengeführt sind, wobei im Zweig Z2 dem Transversalfilter T'j (mit dem zugeordneten Steuereingang e'j) noch ein Quadraturfilter Q, auch Hilberttransformator genannt, nachgeschaltet ist.

In das Ausführungsbeispiel nach **FIG. 3** für einen Entzerrer, der zwischen einem Eingang E und einem Ausgang Au liegt, sind nun solche Filterblöcke FB, wie anhand von FIG. 2 erläutert, einbezogen. Sie liegen in Schaltungsteilen zwischen einer eingangsseitigen Verzweigung 31 und einer ausgangsseitigen Summen/Differenz-Bildungseinrichtung SD (SD-Einrichtung). Von der eingangsseitigen Verzweigung 31 führt zunächst ein Ast AeO in Form einer durchgehenden Leitung zu der SD-Einrichtung SD. Ein zweiter Ast Ae1 verzweigt sich in zwei Wege W1 und W2, die parallel zueinander zur Summen/Differenz-Bildungseinrichtung SD führen. In beiden Wegen befinden sich jeweils in einer Reihenschaltung sowohl ein Filterblock als auch ein Funktionsgeber, jedoch in unterschiedlicher Reihenfolge, hintereinander geschaltet. Die Funktionsgeber f1 bzw. f1' sind beide untereinander gleich aufgebaut und verursachen nichtlineare Verzerrungen der niedrigsten Ordnung, um deren Entzerrung es bei der Anwendung des dargestellten Entzerrers geht. Die Filterblöcke FB1 bzw. FBa haben Steuereingänge e1, e'1, bzw. ea, e'a und sind so aufgebaut, wie in FIG. 2 dargestellt.

Die Signale der beiden Wege W1 und W2 werden in einem Summierer 7 vereint und das dabei entstehende Signal

. . .

gelangt zu einem Summierer 8, zu dessen anderem Eingang der Ast Ae0 führt.

Die Funktionsgeber f1 bzw. f1' sind bevorzugt so gestaltet, daß sie ein Ausgangssignal y in Abhängigkeit von einem Eingangssignal x nach der Funktion $y = x^3$ liefern, um auf diese Weise Verzerrungen dritter Ordnung kompensieren zu können.

Sollen auch noch Verzerrungen höherer Ordnung kompensiert werden, so kann von der eingangsseitigen Verzweigung 31 noch ein weiterer Ast Ae2 abzweigen, der im Prinzip den gleichen Aufbau hat und die gleiche Anschlußweise über Summierer 72 und 82 wie der Ast Ae1, wobei jedoch Funktionsgeber f2 bzw. f2' vorgesehen sind, deren Ausgangs/-Eingangs-Kennlinie Verzerrungen höherer Ordnung hervorruft und insbesondere der Gleichung $y = x^5$ folgt. Zur Entzerrung von Verzerrungen noch höherer Ordnung können weitere, hier nur angedeutete Äste Ae3,... vorgesehen sein.

Um den gezeigten Entzerrer zu einem adaptiven Entzerrer weiterzubilden, ist hinter dem Entzerrerausgang Au an einem Ausgang A der dann entzerrten Übertragungsstrecke ein Leistungsmesser LM angeschlossen, der außerhalb oder in einer Lücke des Nutzfrequenzbandes der Übertragungsstrecke (z. B. Frequenzmultiplex-Übertragungsstrecke) die auftretende Störleistung mißt, welche durch die nichtlinearen, dynamischen Verzerrungen der Übertragungsstrecke hervorgerufen ist. Dieser Leistungsmesser LM liefert eine unipolare Spannung als Gütekriterium für die Entzerrung der Übertragungsstrecke und steuert damit einen Optimator O

...

in an sich bekannter Weise (z.B. Wiss. Ber. AEG-Telefunken 43 (1970) 2, S. 101-1o7, insbesondere S. 102 und
103 mit Bildern 3 und 4), so daß sich automatisch diejenige Entzerrereinstellung mit Hilfe der Steuergrößen e1,
e'1, ea, e'a, e2, e'2, eb, e'b usw. ergibt, daß der Betrag
der unipolaren Spannung und damit die Störleistung am
Ausgang A der Übertragungsstrecke auf einem Minimum
gehalten wird. Der Entzerrer mit seiner Eingangsklemme E
und seiner Ausgangsklemme Au kann dabei entweder als
Vorverzerrer vor oder als Nachentzerrer nach dem zu
entzerrenden Objekt in den Übertragungsweg eingefügt sein.

FIG. 4 zeigt ein weiteres Ausführungsbeispiel eines
Entzerrers, der zwischen seinem Eingang E' und seinem
Ausgang Au' liegt. Eingangsseitig ist ein Filterblock FB1
mit nachgeschaltetem Summen- oder Differenzbildner S'
vorgesehen, dem das Eingangssignal auch noch direkt über
eine Leitung 9 zugeführt ist. Eine analoge Anordnung mit
einer Leitung 10, einem Filterblock FB2 und einem Summen-
oder Differenzbildner S'' befindet sich ausgangsseitig.

Zwischen diesen beiden gleich aufgebauten, aber unter
Umständen über Steuereingänge e1, e'1 bzw. e2, e'2
unterschiedlich eingestellten Anordnungen befindet sich,
abgesehen von einer Summen/Differenz-Bildungseinrichtung
SD' (SD'-Einrichtung), hinter einer Gabelung 41 eine
Anzahl von Strängen St0, St1, St2 usw., deren eine über
zwei hinausgehende Anzahl erforderlich ist, wenn nicht nur
Verzerrungen niedrigster Ordnung entzerrt werden sollen.
Dementsprechend enthalten die Stränge St1, St2,...
Funktionsgeber f1, f2 analog zu den gleichbezeichneten

...

Funktionsgeber in FIG. 3. Diesen in FIG. 4 dargestellten Funktionsgebern folgen jeweils ein Verteiler VT1, VT2, von welchem zwei Pfade abzweigen, beispielsweise P1, P2, die parallel zueinander verlaufend letztlich zu einem Summierer 11 in der SD'-Einrichtung führen. Wenigstens einer der Pfade, nämlich P2, enthält ein Quadraturfilter Q. Beide Pfade enthalten außerdem (bei Pfad P2 in Reihenschaltung) je ein Bewertungsglied B1, B'1 mit einem jeweils zugeordneten Steuereingang b1 bzw. b'1. Es kann auch nur ein Bewertungsglied entweder im ersten oder zweiten Pfad vorgesehen sein und das zweite Bewertungsglied dem Verteiler VT1 vorgeschaltet oder dem Summierer 11 nachgeschaltet sein. Dies gilt analog auch für die Transversalfilter in FIG. 2.

Das Ausgangssignal des Summierers 11 ist einem Eingang eines weiteren Summierers 12 zugeführt, dessen anderem Eingang Signale aus dem Strang St0 zugeleitet werden. Dem Summierer 12 folgen weitere Summierer 13 usw. zur Überlagerung weiterer Signale, die aus weiteren Strängen St2 usw. kommen.

Am Ausgang A der dort schon entzerrten Übertragungsstrecke ist wieder ein Leistungsmesser LM' mit nachfolgendem Optimator O' in Analogie zur FIG. 3 vorgesehen. Dieser Optimator O' steuert mit Hilfe von Steuergrößen e1, e'1, e2, e'2 bzw. b1, b'1, b2, b'2 usw. die durch entsprechende Steuereingangsbezeichnungen gekennzeichneten Filterblöcke FB1, FB2 bzw. Bewertungsglieder B1, B'1, B2, B'2 usw.

In **FIG. 5** ist ein weiteres Ausführungsbeispiel eines erfindungsgemäßen Entzerrers zum Entzerren von nichtlinearen Signalen dargestellt für den Fall, daß dynamische Verzerrungen vernachlässigbar sind. Die dort enthaltenen Funktionsgeber f und Bewertungsglieder B bilden dort jeweils eine steuerbare Funktionsgebereinheit Sf, die, wie aus der später erläuterten FIG. 6 hervorgeht, einfach zu integrieren ist, wobei sämtliche dort verwendeten Funktionsgeber Sf die gleiche Schaltung mit gleichdimensionierten Bauelementen enthalten.

Einer nach dem Entzerrereingang E' angeordneten Verzweigung 51 mit wenigstens zwei Ästen St0 und (St1 mit St'1), wobei hier mit gleichem Index bezeichnete Äste als ein einziger Ast aufgefaßt werden, ist eine gemeinsame Summen/Differenz-Bildungseinrichtung SD' (SD'-Einrichtung) nahe dem Entzerrerausgang Au' nachgeschaltet. Der zweite Ast enthält in zwei zueinander parallel verlaufenden Wegen St1 und St'1 jeweils die Reihenschaltung eines Vorverzerrers und eines Bewertungsgliedes, wobei in einem der beiden Wege zusätzlich ein Quadraturfilter geschaltet ist. Im Ausführungsbeispiel enthält der Weg St1 die Reihenschaltung des Funktionsgebers f1 mit dem Bewertungsglied B1. Im zweiten Weg St'1 liegt die Reihenschaltung eines Funktionsgebers f'1, eines Bewertungsgliedes B'1 und des Quadraturfilters Q. Die beiden Wege sind in der SD'-Einrichtung SD' mittels des Summierers 11 wieder zusammengeführt.

Das Ausgangssignal des Summierers 11 ist einem Eingang eines weiteren Summieres 12 zugeführt, dessen anderem

...

0054811
UL 79/136

Eingang Signale aus dem Ast St0 zugeleitet werden. Da nicht nur Verzerrungen niedrigster Ordnung entzerrt werden sollen, sind weitere Äste z. B. (St2 mit St'2) vorgesehen, die die gleiche Schaltung wie der zweite Ast (St1 mit St'1) aufweisen.

Wie die Figur erkennen läßt, sind nur noch wenige Steuerleitungen für die Bewertungsglieder B1, B'1; B2, B'2 usw. erforderlich, so daß der Optimator ebenfalls einfach ausgeführt sein kann und dadurch in relativ kurzer Zeit die optimale Entzerrung einstellen kann.

In **FIG. 6** ist eine besonders einfache und vorteilhafte Schaltungsanordnung eines Funktionsgebers mit Bewertungsglied dargestellt, der in FIG. 5 mit Sf bezeichnet ist und dort jeweils in einem strichlierten Kasten dargestellt ist. Wie FIG. 6 zeigt, wird das Eingangssignal x über den Eingang St einem ersten Eingang eines ersten Differenzverstärkers $V_1$ zugeführt, dessen Ausgang über einen Widerstand $R_0$ mit dem Emitter eines in Basisschaltung betriebenen Transistors $T_1$ verbunden ist. Der Widerstandswert des Widerstandes $R_0$ ist hierbei niedriger als der Eingangswiderstand des Transistors $T_1$ in Basisschaltung. Der Kollektor des in Basisschaltung betriebenen Transistors $T_1$ ist Ausgang des mit f bezeichneten Funktionsgebers.

Der Ausgang des Differenzverstärkers $V_1$ ist zusätzlich über einen Widerstand $R_1$ oder einen Tiefpaß mit dem ersten Eingang eines Differenzverstärkers $V_2$ verbunden. Der Tiefpaß besteht im Ausführungsbeispiel aus der Reihenschaltung des Widerstandes $R_1$ mit einem nach Bezugspotential geschalteten Kondensators C, wobei der Verbindungspunkt zwischen Widerstand $R_1$ und Kondensator C mit dem

...

ersten Eingang des Differenzverstärkers $V_2$ verbunden ist. Die Ausgangsleitung des Differenzverstärkers $V_2$ führt zum zweiten Eingang des Differenzverstärkers $V_1$.

Die Bauteile des Bewertungsgliedes befinden sich in dem mit B bezeichneten strich-punktierten Rahmen der FIG. 6. Der Eingang des Bewertungsgliedes besteht aus den miteinander verbundenen Emittern zweier steuerbarer Transistoren $T_2$ und $T_3$. Die Basis des Transistors $T_2$ ist mit einer ersten Konstantstromquelle $U_0$ verbunden und die Basis des Transistors $T_3$ ist an dem Ausgang eines Differenzverstärkers $V_3$ angeschlossen, dessen einem Eingang die Steuerspannung b für das Bewertungsglied B zuführbar ist.

Die Kollektoren der steuerbaren Transistoren $T_2$ und $T_3$ sind zum einen jeweils mit einem Eingang eines Differenzverstärkers $V_4$ und zum anderen jeweils über einen Arbeitswiderstand $R_2$ bzw. $R_3$ mit der Betriebsspannungsquelle $U_B$ verbunden. Die Ausgangsleitung des Differenzverstärkers $V_4$ führt zum Ausgang der Schaltungsanordnung und führt das Signal y.

Da Halbleiterbauelemente, insbesondere Transistoren, bezüglich ihrer elektrischen Eigenschaften außerordentlich temperaturabhängig sind, umfaßt die in FIG. 6 dargestellte Schaltungsanordnung des weiteren eine mit K bezeichnete Kompensationsschaltung. Wie ersichtlich, weist die Kompensationsschaltung eine dem in Basisschaltung betriebenen Transistors $T_1$ und dem Bewertungsglied B entsprechende Schaltung auf. Die sich entsprechenden Bauelemente wurden mit gleichem Index bezeichnet und mit einem Apostroph versehen. Der Ausgang des Differenzverstärkers

...

$V_4'$ ist jedoch mit dem anderen Eingang des Differenzverstärkers $V_3$ verbunden. Ferner wird der Emitter des in
Basisschaltung betriebenen Transistors $T_1'$ von einer
Konstantstromquelle I gespeist und ist an den zweiten
Eingang des Differenzverstärkers $V_2$ angeschlossen.

Sämtliche Differenzverstärker der Schaltungsanordnung
gemäß FIG. 6 haben Eingangswiderstände über 100 kOhm,
Ausgangswiderstände unter 10 Ohm und Spannungsverstärkungen über 1000.

Die verlangte Nichtlinearität des Funktionsgebers, der in
FIG. 6 in einem mit f bezeichneten strich-punktierten
Rahmen dargestellt ist, wird mittels der nichtlinearen
Spannungs-Stromkennlinie der Emitter-Basis-Diodenstrecke
des Transistors $T_1$ erzeugt. Hierzu wird der Transistor $T_1$
vom Eingang St her über den Differenzverstärker $V_1$ und
über den sehr niederohmigen Widerstand $R_0$ von etwa 10 Ohm,
der niederohmiger als der Eingangswiderstand des Transistors $T_1$ in Basisschaltung sein soll, nahezu spannungsgesteuert. Dadurch wird der Emitterstrom des Transistors
$T_1$ und damit sein Kollektorstrom nichtlinear von der
Eingangsspannung x abhängig.

Zum Zweck der Steuerung des Bewertungsgliedes B wird der
Kollektorstrom des Transistors $T_1$ durch eine symmetrische
Differenzverstärkerstufe mit den Transitoren $T_2$ und $T_3$
geleitet, deren Basen an niederohmigen Quellen, der
Konstantspannungsquelle $U_0$ und dem Ausgang des Differenzverstärkers $V_3$ liegen. Je nach Größe der Spannungsdifferenz zwischen den Basen der Transistoren $T_2$ und $T_3$
teilt sich der Kollektorstrom des Transistors $T_1$ in den
beiden Transistoren $T_2$ und $T_3$ verschieden auf.

...

Als Ausgangsgröße der symmetrischen Differenzverstärkerstufe mit den Transistoren $T_2$ und $T_3$ wird der zwischen den beiden gleich großen Arbeitswiderständen $R_2$ und $R_3$ auftretende Spannungsunterschied verwendet, so daß sich mit der Basisspannung des Transistors $T_3$ bei konstanter Spannung $U_0$ an der Basis des Transistors $T_2$ der Gewichtsfaktor am Ausgang des Differenzverstärkers $V_4$ nach beiden Polaritäten, also auf positive und negative Werte, steuern läßt.

Obwohl bei einer adaptiven Entzerrung gewisse Änderungen der Funktionsgeberkennlinien infolge von Temperaturschwankungen ausgeregelt werden, sind in der bevorzugten Schaltungsanordnung nach FIG. 6 zur Kompensation des durch die Spannungsansteuerung bedingten Temperaturgangs des Kollektorstromes des Transistors $T_1$ zusätzliche kompensierende Maßnahmen vorgesehen. So wird die Schaltungsanordnung mit den Transistoren $T_1$, $T_2$, $T_3$ in engem Wärmekontakt mit einer zweiten Anordnung mit den Transistoren $T_1'$, $T_2'$, $T_3'$ der Kompensationsschaltung K betrieben, in dem sich die sechs Transistoren beider Anordnungen auf einem einzigen Halbleiterchip befinden.

Die Kompensationsschaltung K unterscheidet sich nur dadurch von der Schaltung für den Funktionsgeber f und für das Bewertungsglied B, daß sie von einer Gleichstromquelle I gespeist wird, so daß dadurch der Strom durch den Transistor $T_1'$ und durch die Differenzstufe mit den Transistoren $T_2'$ und $T_3'$ unabhängig von der Temperatur konstant bleibt. An diesen Betriebszustand werden die Arbeitswiderstände der zu kompensierenden Anordnung mit den Transistoren $T_1$, $T_2$ und $T_3$ mittels der hochverstärkenden Differenzverstärker $V_2$ und $V_4'$ gleichspannungsmäßig

...

angebunden. Diese Anbindung geschieht in der Weise, daß die den Arbeitspunkt bestimmende Gleichspannung für den Emitter des Transistors $T_1$, die über den Tiefpaß $R_1/C$ am Ausgang des Verstärkers $V_1$ liegt, durch den Differenzverstärker $V_2$ auf der Emitterspannung des Transistors $T_1'$ gehalten wird.

Mit Hilfe des Differenzverstärkers $V_4'$ wird der Temperaturgang des Gewichtsfaktors der Ausgangsspannung y kompensiert, in dem der Spannungsunterschied zwischen den Arbeitswiderständen $R_2'$ und $R_3'$ ausgewertet wird. Die Widerstände $R_2'$, $R_3'$, $R_2$ und $R_3$ haben alle gleiche Widerstandswerte.

Die Funktionsgeber der verschiedenen Ordnungen, also für $y = x^3$, $y = x^5$, usw. unterscheiden sich voneinander nur in ihrem Arbeitspunkt in dem die Emitter-Basis-Strecke des Transistors $T_1$ betrieben wird. Zur Einstellung dieses punktes wird über den zweiten Eingang des Differenzverstärkers $V_1$ eine Gleichspannung ganz bestimmter Größe, die über den Konstantstrom I bestimmt wird, dem Eingangssignal x additiv überlagert.

Die in FIG. 6 gezeigte Schaltungsanordnung hat den besonderen Vorteil, daß mit ihr mindestens die dritten und fünften Verzerrungsordnungen lediglich durch Verändern der Einströmung I erzeugt werden können, ohne daß Schaltungsänderungen erforderlich sind.

...

Licentia Patentverwaltungs-GmbH        Z13 PTL-UL/Sar/lh
Theodor-Stern-Kai 1                     UL 79/136
D-6000 Frankfurt 70                     Aktz.: P 30 47 292.5

Patentansprüche

1. Entzerrer zum Entzerren von nichtlinear verzerrten
Signalen
    a) mit hintereinander geschalteten Laufzeitgliedern
       (L2, L3), vor und hinter denen jeweils Signalanteile
       abgreifbar sind zur weiteren Verarbeitung unter
       Verwendung von Bewertungsgliedern (A1, A2,...) und
       Summen- oder Differenzbildnern (S2, S3,...),

gekennzeichnet durch folgende Merkmale:
    b) die Laufzeitglieder (L2, L3,...) und Bewertungsglieder (A1, A2,...) sowie die Summen- oder Differenzbildner (S2, S3,...) sind Teil von Transversalfiltern (Tj, T'j);
    c) eine Verzweigung (21) in wenigstens zwei Zweige (Z1,
       Z2) mit einem Quadraturfilter (Q) (Hilberttransformator) in einem Zweig (Z2) und einem Transversalfilter (Tj, T'j) in wenigstens einem der Zweige (Z1, Z2) und mit den Zweigen nachgeschaltetem Summen- oder Differenzbildner (S) bilden zusammen einen Filterblock (FB1, FBa,...);

d) einer nahe dem Entzerrereingang (E) angeordneten, übergeordneten Verzweigung (31) mit wenigstens zwei Ästen (Ae0, Ae1, Ae2,...) ist eine gemeinsame Summen/-Differenz-Bildungseinrichtung (SD) nahe dem Entzerrerausgang (Au) nachgeschaltet;

e) der zweite (Ae1) der Äste enthält in zwei zueinander parallel verlaufenden, zur Summen/Differenz-Bildungseinrichtung (SD) führenden Wegen (W1, W2) jeweils einen Filterblock (FB1, FBa) und jeweils einen Funktionsgeber (f1, f1') in unterschiedlicher Reihenfolge hintereinandergeschaltet, wobei beide Funktionsgeber für eine Vorverzerrung einer gemeinsamen, bestimmten Ordnung vorgesehen sind;

f) ein gegebenenfalls vorgesehener weiterer Ast (Ae2) oder weitere Äste unterscheiden sich voneinander und vom zweiten Ast (Ae1) dadurch, daß ihre Funktionsgeber (f2, f2') von Ast zu Ast jeweils für unterschiedliche Ordnungen vorgesehen sind (FIG. 3).

2. Entzerrer zum Entzerren von nichtlinear verzerrten Signalen mit den Merkmalen a bis c des Patentanspruchs 1, gekennzeichnet durch folgende Merkmale:

g) am Eingang (E') und am Ausgang (Au') des Entzerrers (FIG. 4) ist jeweils eine Anordnung vorgesehen, die einen Summen- oder Differenzbildner (S', S'') enthält, dem außer dem Ausgangssignal eines jeweils zugeordneten, im Signalweg liegenden Filterblockes (FB1, FB2) auch noch ein unter Umgehung dieses

...

Filterblockes zugeleitetes Signal (Leitung 9 bzw. 10)
zugeführt ist;

h) zwischen den Anordnungen liegt eine Gabelung (41) mit
   mindestes zwei nachfolgenden Strängen (St0, St1), die
   über eine Summen/Differenz-Bildungseinrichtung (SD')
   wieder zusammengeführt sind und von denen der zweite
   (St1) der beiden Stränge einen Funktionsgeber (f1)
   für eine Vorverzerrung einer bestimmten Ordnung
   enthält, dem eine Einrichtung mit einem Verteiler
   (VT1) nachgeschaltet ist, von dem zwei Pfade (P1, P2)
   parallel zueinander zur Summen/Differenz-Bildungseinrichtung (SD') führen, von denen ein Pfad (P2) ein
   Quadraturfilter (Q) (Hilberttransformator) und
   wenigstens ein Pfad (P1, P2) ein Bewertungsglied (B1
   bzw. B'1) enthält;

i) ein gegebenenfalls vorgesehener weiterer Strang (St2)
   oder weitere Stränge unterscheiden sich voneinander
   und vom zweiten Strang (St1) dadurch, daß ihre
   Funktionsgeber (f2) für unterschiedliche Ordnungen
   vorgesehen sind (FIG. 4).

3. Entzerrer zum Entzerren von nichtlinear verzerrten
Signalen,

k) mit einer nahe dem Entzerrereingang (E') angeordneten
   Verzweigung (51) in wenigstens zwei Äste (St0; St1,
   St'1;...), denen eine gemeinsame Summen/Differenz-
   Bildungseinrichtung (SD') nahe dem Entzerrerausgang
   (Au') nachgeschaltet ist;

l) mit einem gegebenenfalls vorgesehenen weiteren Ast
   (St2, St'2) oder weiteren Ästen, die sich voneinander
   und vom zweiten Ast (St1, St'1) dadurch unterscheiden, daß ihre Funktionsgeber (f2, f'2) für unter-

...

schiedliche Ordnungen vorgesehen sind,
gekennzeichnet durch folgendes Merkmal:

m) der zweite der Äste enthält in zwei zueinander
parallel verlaufenden Wegen (St1, St'1), die über
eine Summen/Differenz-Bildungseinrichtung (SD')
wieder zusammengeführt sind, jeweils die Reihenschaltung eines Funktionsgebers (f1, f'1) und eines
Bewertungsgliedes (B1 bzw. B'1), wobei in einem der
beiden Wege zusätzlich ein Quadraturfilter (Q)
geschaltet ist (FIG. 5).

4. Entzerrer nach Anspruch 1, 2 oder 3,dadurch gekennzeichnet, daß die Bewertungsglieder (A1, A2,...; B1, B'1, B2,
B'2,...) bezüglich ihrer Bewertungsfaktoren veränderbar
sind.

5. Entzerrer nach Anspruch 4, dadurch gekennzeichnet, daß
der Entzerrer einen Leistungmesser (LM, LM') aufweist für
in einer Lücke oder außerhalb des Nutzfrequenzbandes
auftretende Störleistung, der an dem Ausgang (A) der
entzerrten Übertragungsstrecke anschließbar ist und zur
Steuerung eines Optimators (O, O') dient, der seinerseits
zur Steuerung der Bewertungfaktoren vorgesehen ist.

6. Schaltungsanordnung für einen Funktionsgeber (f) mit
Bewertungsglied (B), insbesondere für einen Entzerrer nach
Anspruch 3, gekennzeichnet durch folgende Merkmale:
a) das Eingangssignal (x) des Funktionsgebers ist einem
ersten Eingang eines ersten Differenzverstärkers (V1)
zugeführt, dessen Ausgang über einen niederohmigen
Widerstand ($R_0$) mit dem Emitter eines in Basisschaltung betriebenen ersten Transistors ($T_1$) verbunden

...

ist, wobei der Widerstandswert des niederohmigen Widerstandes ($R_0$) niedriger als der Eingangswiderstand des ersten Transistors ($T_1$) ist und der Kollektor des ersten Transistors ($T_1$) der Ausgang des Funktionsgebers (f) ist;

b) der Ausgang des ersten Differenzverstärkers ($V_1$) ist zusätzlich über einen Widerstand ($R_1$) oder einen Tiefpaß ($R_1$, C) mit dem ersten Eingang eines zweiten Differenzverstärkers ($V_2$) verbunden, dessen Ausgang mit dem zweiten Eingang des ersten Differenzverstärkers ($V_1$) verbunden ist;

c) der Eingang des Bewertungsgliedes (B) besteht aus den miteinander verbundenen Emittern zweier steuerbarer Transistoren ($T_2$, $T_3$), wobei die Basis des einen Transistors ($T_2$) mit einer ersten Konstantstromquelle ($U_0$), die Basis des anderen Transistors ($T_3$) mit dem Ausgang eines dritten Differenzverstärkers ($V_3$) verbunden ist, dessen einem Eingang die Steuerspannung (b) für das Bewertungsglied (B) zuführbar ist, und die Kollektoren der steuerbaren Transistoren ($T_2$, $T_3$) zum einen jeweils mit einem Eingang eines vierten Differenzverstärkers ($V_4$) und zum anderen jeweils über einen Arbeitswiderstand ($R_2$ bzw. $R_3$) mit einer Betriebsspannungsquelle ($U_B$) verbunden sind und der Ausgang des vierten Differenzverstärkers ($V_4$) der Ausgang (y) der Schaltungsanordnung ist;

d) es ist eine Kompensationsschaltung (K) zur Kompensation temperaturbedingter Parameteränderungen vorgesehen, die eine dem in Basisschaltung betriebenen ersten Transistor ($T_1$) und dem Bewertungsglied (B) entsprechende Schaltung aufweist ($T_1'$, $T_2'$, $T_3'$,

...

$U_o'$, $R_2'$, $R_3'$, $V_4'$), wobei jedoch der Ausgang des dem vierten Differenzverstärker ($V_4$) entsprechenden Differenzverstärkers ($V_4'$) mit dem anderen Eingang des dritten Differenzverstärkers ($V_3$) verbunden ist und der Emitter des dem ersten Transistors ($T_1$) entsprechenden Transistors ($T_1$) von einer Konstantstromquelle (I) gespeist ist und an den zweiten Eingang des zweiten Differenzverstärkers ($V_2$) angeschlossen ist.

...

FIG. 1

FIG. 2

FIG. 3

FIG. 4

0054811

FIG. 5

0054811

FIG. 6

Europäisches
Patentamt

**EUROPÄISCHER RECHERCHENBERICHT**

0054811

Nummer der Anmeldung

EP 81 11 0188

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | THE BELL SYSTEM TECHNICAL JOURNAL, Band 52, Nr. 2, Februar 1973 NEW YORK (US) R.D. GITLIN u.a.: "Passband equalization of differentially phase-modulated data signals", Seiten 219-238 | |
| | * Seite 225, Zeilen 9-17; Seite 237, Zeilen 27-31 * | 1,4 |
| | --- | |
| D/A | DE - A - 3 002 995 (NIPPON TELE-GRAPH & TELEPHONE) | |
| | * Seite 7, Zeilen 3-12; Seite 16, Zeile 30 - Seite 17, Zeile 19 * | 1,5 |

**KLASSIFIKATION DER ANMELDUNG (Int Cl.)**

H 04 B 3/14

**RECHERCHIERTE SACHGEBIETE (Int Cl.)**

H 04 B    3/06
                3/14
H 04 L 27/00

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

X  Der vorliegende Recherchenbericht wurde für alle Patentansprüche erstellt.

| Recherchenort | Abschlußdatum der Recherche | Prüfer |
|---|---|---|
| Den Haag | 24-03-1982 | HOLPER |

EPA form 1503.1   06.78